# EUROPEAN PATENT APPLICATION

(11) **EP 2 868 391 A1**
(43) Date of publication of application: **06.05.2015**
(21) Application number: 13809598.9
(22) Date of filing: 13.06.2013
(51) Int. Cl.: B05C 5/04, B05D 1/32

(54) **APPLICATION DEVICE, REMOVAL DEVICE, APPLICATION AND REMOVAL SYSTEM AS WELL AS APPLICATION METHOD, REMOVAL METHOD, AND APPLICATION AND REMOVAL METHOD**

(30) Priority: 25.06.2012 JP 2012142499; 11.03.2013 JP 2013047545
(71) Applicant: JE International Corporation, Nagoya-shi, Aichi 460-0002 (JP)
(72) Inventor: KIM, Minsu, Nagakute-shi Aichi 480-1142 (JP); KONISHI, Yukio, Chikushino-shi Fukuoka 818-0024 (JP)
(74) Representative: O'Neill, Michelle
(86) International application number: PCT/JP2013/066347
(87) International publication number: WO 2014/002783

(57) **Abstract**

The present invention is an application device (10) for applying a hot melt coating material (A) only on the non-treated surfaces (S2) of a coating object, which comprises treated surfaces (S1) where surface treatment is to be performed and non-treated surfaces (S2) where surface treatment is not to be performed, the device comprising: an inkjet unit (20) for discharging melted coating material (A) toward the coating object; a supply unit (30) for supplying the melted coating material (A) to the inkjet unit (20); and a heating means (31) for melting the coating material (A), the heating means being provided on the supply unit (30). Another invention removes coating material (A), which is a paraffin-containing masking agent and has been coated only on the non-treated surfaces (S2) of the coating object, still in solid form from the coating object using a refrigerant of a temperature less than the melting point of paraffin or in liquid form from the coating object using a fluid of a temperature at or above the melting point of paraffin. Said various configurations allow the formation of masking on small, complex non-treated surfaces as well as easy removal of the masking agent.

## Description

### [Technical Field]

The present invention disclosed herein relates to an application device, a removal device, an application and removal system as well as an application method, a removal method, and an application and removal method.

### [Background Art]

In surface treatments such as plating and etching, a masking agent is used to form a desired pattern.

Typically, after a non-treated surface of a substrate, which is not subjected to a surface treatment, is covered with a masking tape, a predetermined surface treatment is performed and the masking tape is peeled off using a predetermined peeling device (e.g., see Patent Document 1).

Recently, in line with the complication of the shapes of electronic components as objects subjected to a surface treatment, the demand for performing a surface treatment on a complex and small non-treated surface has increased. However, since masking is performed by a masking tape in the technique described in Japanese Patent Application Laid-Open Publication No. 2004-43852, it may be difficult to mask the complex and small non-treated surface. Also, for example, when the object is immersed in a plating solution in a state in which the masking tape is attached to only an attachable portion, the plating solution is coated even on unnecessary portions to cause the waste of plating materials.

Furthermore, a peeling device for peeling the masking tape must be prepared, and cost and time required for the peeling of the masking tape are increased.

### [Disclosure]

### [Technical Problem]

The present invention provides an application device and an application method which may mask a complex and small non-treated surface, a removal device and a removal method which may easily remove a masking agent, and an application and removal system.

### [Technical Solution]

The object of the present invention is achieved in accordance with exemplary embodiments described in (1) to (32) below.
(1) An application device coating only a non-treated surface of a coating object, which includes a treated surface subjected to a surface treatment and the non-treated surface not subjected to the surface treatment, with a heat-fusible coating material that is a solid at room temperature and is liquefied by heating, the application device including: an inkjet unit for discharging the molten coating material toward the coating object; a supply unit for supplying the molten coating material to the inkjet unit; and a heating means which is provided in the supply unit and melts the coating material.
(2) The application device described in (1), wherein the supply unit includes: a tank into which the coating material in a solid state or a liquid state is introduced; a connecting part connecting between the inkjet unit and the tank; and a sending unit for sending the molten coating material in the tank to the inkjet unit though the connecting part, and the heating means includes: a first heating unit provided in the tank for melting the coating material; and a second heating unit provided on the connecting part for maintaining a molten state of the coating material.
(3) The application device described in (2), wherein the sending unit is composed of a pump mechanism or a natural flow-down mechanism in which the molten coating material is sent by flowing down from a higher place to a lower place by disposing the tank above the inkjet unit.
(4) The application device described in any one of (1) to (3), further including an adjusting unit which adjusts a position of the inkjet unit by three-dimensionally and relatively moving the inkjet unit against the coating object and freely adjusts a position of the coating object on which the coating material is coated.
(5) The application device described in (4), wherein the adjusting unit includes a first rotating part and a second rotating part which incline the inkjet unit with respect to a landing surface by relatively rotating the inkjet unit with respect to the coating object around axes in a first direction and a second direction that are orthogonal to each other on the landing surface of the coating object on which the coating material is landed.
(6) The application device described in (5), wherein a column of inkjet nozzles provided in the inkjet unit is arranged in the second direction and the coating material is sequentially discharged along the first direction by the inkjet unit, and the adjusting unit further includes a third rotating part which relatively rotates the inkjet unit with respect to the coating object around an axis in a third direction orthogonal to the landing surface and inclines the column of the inkjet nozzles with respect to the second direction.
(7) The application device described in any one of (1) to (6), further including another inkjet unit which discharges the coating material in a direction that is different from a direction in which the coating material is discharged by the inkjet unit.
(8) The application device described in any one of (1) to (7), wherein the coating material is a masking agent including paraffin.
(9) The application device described in (8), wherein a viscosity of the coating material at 80°C is in a range of 5 mPa/s to 30 mPa/s.
(10) The application device described in (8) or (9), wherein an amount of the paraffin is in a range of 85 wt% or more to less than 100 wt% based on a total weight of the masking agent.
(11) The application device described in any one of (1) to (10), further including: a transport unit for relatively transporting the inkjet unit and the coating object; and a temperature control unit which is provided in the transport unit and controls a temperature of the coating object.
(12) A removal device including a cooling removal unit which removes a coating material, a masking agent including heat-fusible paraffin that is a solid at room temperature and is liquefied by heating, which is coated only on a non-treated surface of a coating object that includes a treated surface subjected to a surface treatment and the non-treated surface not subjected to the surface treatment, as a solid from the coating object by a refrigerant having a temperature less than a melting point of the paraffin.
(13) The removal device described in (12), further including a cooling-side recovery unit that recovers the masking agent in a solid form, which is removed by the cooling removal unit, from the refrigerant, wherein the masking agent recovered in the cooling-side recovery unit is reused as the coating material described in any one of (1) to (11).
(14) A removal device including: a cooling removal unit which removes a coating material, a masking agent including heat-fusible paraffin that is a solid at room temperature and is liquefied by heating, which is coated only on a non-treated surface of a coating object that includes a treated surface subjected to a surface treatment and the non-treated surface not subjected to the surface treatment, as a solid from the coating object by a refrigerant having a temperature less than a melting point of the paraffin; and a melt removal unit which removes the coating material remaining on the non-treated surface, after the removal by the cooling removal unit, from the coating object by melting and liquefying the coating material by a fluid having a temperature above the melting point of the paraffin.
(15) The removal device described in (14), further including: a cooling-side recovery unit that recovers the masking agent in a solid form, which is removed by the cooling removal unit, from the refrigerant; and a melt-side recovery unit that solidifies the masking agent in a liquid form removed by the melt removal unit and recovers the solidified masking agent, wherein the masking agents recovered in the cooling-side recovery unit and the melt-side recovery unit are reused as the coating material described in any one of (1) to (11).
(16) A removal device including a melt removal unit which removes a coating material, a masking agent including heat-fusible paraffin that is a solid at room temperature and is liquefied by heating, which is coated only on a non-treated surface of a coating object that includes a treated surface subjected to a surface treatment and the non-treated surface not subjected to the surface treatment, from the coating object by melting and liquefying the coating material by a fluid having a temperature above a melting point of the paraffin.
(17) The removal device described in (16), further including a melt-side recovery unit that solidifies the masking agent in a liquid form removed by the melt removal unit and recovers the solidified masking agent, wherein the masking agent recovered in the melt-side recovery unit is reused as the coating material described in any one of (1) to (11).
(18) An application and removal system including: an application device described in any one of (1) to (11); and a removal device described in any one of (12) to (17).
(19) An application method of coating a heat-fusible coating material, which is a solid at room temperature and is liquefied by heating, only on a non-treated surface of a coating object that includes a treated surface subjected to a surface treatment and the non-treated surface not subjected to the surface treatment, the application method including: a supply process of supplying the molten coating material to an inkjet unit; and a discharge process of discharging the coating material supplied in the supply process by the inkjet unit.
(20) The application method described in (19), wherein the supply process includes: an input process of inputting the coating material in a solid form or a liquid form into a tank; a melting process of melting the coating material in a solid form input in the input process; a sending process of sending the coating material melted in the melting process to the inkjet unit; and a melt maintaining process of maintaining a molten state of the coating material in a connecting part connecting between the tank and the inkjet unit.
(21) The application method described in (19) or (20), further including an adjusting process of adjusting a position of the inkjet unit by three-dimensionally and relatively moving the inkjet unit with respect to the coating object before the discharge process and adjusting a position of the coating object on which the coating material is coated.
(22) The application method described in any one of (19) to (21), wherein the coating material is a masking agent including paraffin.
(23) The application method described in (22), wherein a viscosity of the coating material at 80°C is in a range of 5 mPa/s to 30 mPa/s.
(24) The application method described in (22) or (23), wherein an amount of the paraffin is in a range of 85 wt% or more to less than 100 wt% based on a total weight of the masking agent.
(25) The application method described in any one of (19) to (24), further including a transport process of relatively transporting the inkjet unit and the temperature-controlled coating object.
(26) A removal method including a cooling removal process of removing a coating material, a masking agent including heat-fusible paraffin that is a solid at room temperature and is liquefied by heating, which is coated only on a non-treated surface of a coating object that includes a treated surface subjected to a surface treatment and the non-treated surface not subjected to the surface treatment, as a solid from the coating object by a refrigerant having a temperature less than a melting point of the paraffin.
(27) The removal method described in (26), further including a cooling-side recovery process of recovering the masking agent in a solid form, which is removed in the cooling removal process, from the refrigerant, wherein the masking agent recovered by the cooling-side recovery process is reused as the coating material described in any one of (19) to (25).
(28) A removal method including: a cooling removal process of removing a coating material, a masking agent including heat-fusible paraffin that is a solid at room temperature and is liquefied by heating, which is coated only on a non-treated surface of a coating object that includes a treated surface subjected to a surface treatment and the non-treated surface not subjected to the surface treatment, as a solid from the coating object by a refrigerant having a temperature less than a melting point of the paraffin; and a melt removal process of removing the coating material remaining on the non-treated surface after the cooling removal process from the coating object by melting and liquefying the coating material by a fluid having a temperature above the melting point of the paraffin.
(29) The removal method described in (28), further including: a cooling-side recovery process of recovering the masking agent in a solid form, which is removed in the cooling removal process, from the refrigerant; and a melt-side recovery process of solidifying the masking agent in a liquid form removed in the melt removal process and recovering the solidified masking agent, wherein the masking agents recovered by the cooling-side recovery process and the melt-side recovery process are reused as the coating material described in any one of (19) to (25).
(30) A removal method including a melt removal process of removing a coating material, a masking agent including heat-fusible paraffin that is a solid at room temperature and is liquefied by heating, which is coated only on a non-treated surface of a coating object that includes a treated surface subjected to a surface treatment and the non-treated surface not subjected to the surface treatment, from the coating object by melting and liquefying the coating material by a fluid having a temperature above a melting point of the paraffin.
(31) The removal method described in (30), further including a melt-side recovery process of solidifying the masking agent in a liquid form removed by the melt removal unit and recovering the solidified masking agent, wherein the masking agent recovered by the melt-side recovery process is reused as the coating material described in any one of (19) to (25).
(32) An application and removal method including: an application method described in any one of (19) to (25); and a removal method described in any one of (26) to (31).

### [Advantageous Effects]

According to the invention described in (1), since a coating material melted by a heating means is discharged by an inkjet unit to coat a non-treated surface of a coating object, a complex and small non-treated surface may be masked.

According to the invention described in (2), since a coating material in a solid form may be placed in a tank, workability may be improved.

According to the invention described in (3), since the coating material may be transferred from the tank to the inkjet unit, workability may be improved.

According to the invention described in (4), the coating material may be coated even on a coating object having a three-dimensional shape.

According to the invention described in (5), the coating material may be coated even on a coating object having a three-dimensional shape.

According to the invention described in (6), since a density of a second directional component of the landed coating material may be increased, failure of plating may be prevented.

According to the invention described in (7), the coating material may be coated even on a coating object having a three-dimensional shape.

According to the invention described in (8), spillage of a coating material ink landed on a landing surface may be reduced.

According to the invention described in (9), since the coating material may be discharged by the inkjet unit, the spillage of the coating material ink landed on the landing surface may be reduced.

According to the invention described in (10), chemical resistance may be sufficiently obtained.

According to the invention described in (11), spillage of a masking agent ink landed on the landing surface may be reduced and relative transportation between the inkjet unit and the coating object is facilitated.

According to the invention described in (12), since a masking agent including paraffin coated on the non-treated surface is removed as a solid from the coating object by a refrigerant having a temperature less than a melting point of the paraffin, the masking agent may be easily removed.

According to the invention described in (13), since the masking agent removed by a cooling removal unit may be reused, the amount of the coating material used may be reduced.

According to the invention described in (14), after removing the masking agent including paraffin coated on the non-treated surface as a solid from the coating object by the refrigerant having a temperature less than the melting point of the paraffin, the masking agent remaining on the non-treated surface is removed from the coating object by melting and liquefying the masking agent by a fluid having a temperature above the melting point of the paraffin. Thus, the masking agent may be more reliably removed.

According to the invention described in (15), since the masking agent removed by the cooling removal unit and the masking agent removed by a melt removal unit may be reused, the amount of the coating material used may be reduced.

According to the invention described in (16), since the masking agent including paraffin coated on the non-treated surface is removed from the coating object by melting and liquefying the masking agent by a fluid having a temperature above the melting point of the paraffin, the masking agent may be easily removed.

According to the invention described in (17), since the masking agent removed by the melt removal unit may be reused, the amount of the coating material used may be reduced.

According to the invention described in (18), a surface treatment may be highly accurately and easily performed on a microscopic area.

According to the invention described in (19), since the molten coating material is supplied to the inkjet unit and the supplied coating material is discharged by the inkjet unit, a complex and small non-treated surface may be masked.

According to the invention described in (20), since the coating material in a solid form is placed in the tank, workability may be improved.

According to the invention described in (21), the coating material may be coated even on a coating object having a three-dimensional shape.

According to the invention described in (22), the spillage of the coating material ink landed on the landing surface may be reduced.

According to the invention described in (23), since the coating material may be discharged by the inkjet unit, the spillage of the coating material ink landed on the landing surface may be reduced.

According to the invention described in (24), chemical resistance may be sufficiently obtained.

According to the invention described in (25), the spillage of the masking agent ink landed on the landing surface may be reduced and the relative transportation between the inkjet unit and the coating object is facilitated.

According to the invention described in (26), since the masking agent including paraffin coated on the non-treated surface is removed as a solid from the coating object by the refrigerant having a temperature less than the melting point of the paraffin, the masking agent may be easily removed.

According to the invention described in (27), since the masking agent removed by a cooling removal process may be reused, the amount of the coating material used may be reduced.

According to the invention described in (28), after removing the masking agent including paraffin coated on the non-treated surface as a solid from the coating object by the refrigerant having a temperature less than the melting point of the paraffin, the masking agent remaining on the non-treated surface is removed from the coating object by melting and liquefying the masking agent by a fluid having a temperature above the melting point of the paraffin. Thus, the masking agent may be more reliably removed.

According to the invention described in (29), since the masking agent removed by the cooling removal process and the masking agent removed by the melt removal process may be reused, the amount of the coating material used may be reduced.

According to the invention described in (30), since the masking agent including paraffin coated on the non-treated surface is removed from the coating object by melting and liquefying the masking agent by a fluid having a temperature above the melting point of the paraffin, the masking agent may be easily removed.

According to the invention described in (31), since the masking agent removed by the melt removal process may be reused, the amount of the coating material used may be reduced.

According to the invention described in (32), a surface treatment may be highly accurately and easily performed on a microscopic area.

### [Description of Drawings]

The accompanying drawings are included to provide a further understanding of the present invention, and are incorporated in and constitute a part of this specification. The drawings illustrate exemplary embodiments of the present invention and, together with the description, serve to explain principles of the present invention. In the drawings:
FIG. 1 illustrates an application and removal system according to a first embodiment of the present invention;
FIG. 2(A) illustrates a schematic view of coating a coating object with a coating material by an inkjet unit of an application device according to the first embodiment of the present invention, and FIG. 2(B) illustrates a state of the coating object after the coating;
FIG. 3 is a sectional view illustrating discharge of the coating material from the inkjet unit;
FIG. 4 is a perspective view illustrating a schematic configuration of a third rotating part of an adjusting unit;
FIG. 5 illustrates a plating unit;
FIG. 6 is a flowchart illustrating a method of plating by the plating unit of FIG. 5;
FIG. 7 illustrates coating objects when each process by the plating unit of FIG. 5 is ended, in which FIGS. 7(A), 7(B), (C), and (D) illustrates the coating objects in an initial state, after the end of a discharge process, after dipping in a plating solution, and after the end of a cooling removal process, respectively;
FIG. 8 illustrates a case where the plurality of inkjet units is prepared;
FIG. 9 illustrates a case where a column of inkjet nozzles is inclined to the Y direction;
FIG. 10 illustrates an application and removal system according to a second embodiment of the present invention;
FIG. 11 illustrates a coating object after the end of a cooling removal process according to the second embodiment of the present invention; and
FIG. 12 illustrates an application and removal system according to a third embodiment of the present invention.

### [Best Mode]

Preferred embodiments of the present invention will be described below in more detail with reference to the accompanying drawings. The present invention may, however, be embodied in different forms and should not be constructed as limited to the embodiments set forth herein. Rather, these embodiments are provided so that this disclosure will be thorough and complete, and will fully convey the scope of the present invention to those skilled in the art.

### <First Embodiment>

Hereinafter, a first embodiment of the present invention will be described with reference to the accompanying drawings. Also, the dimensional ratios of the drawings are exaggerated for convenience of explanation and may be different from the actual ratios.

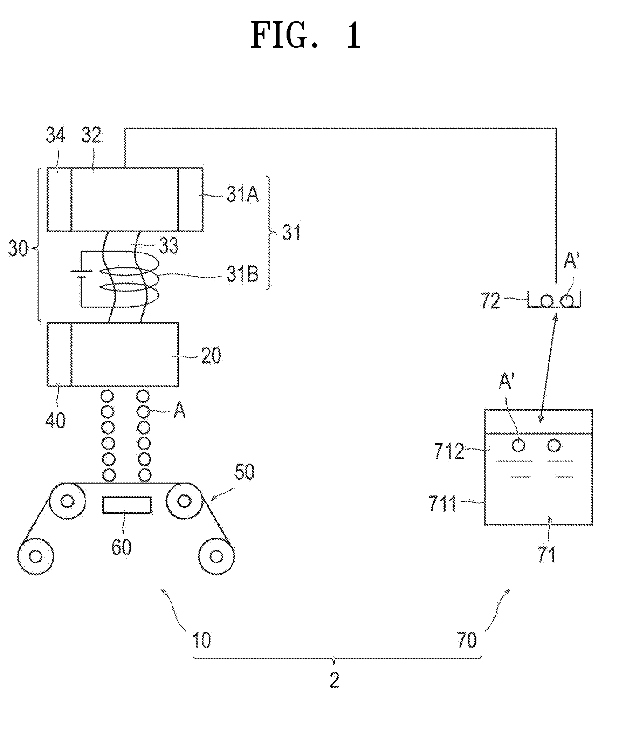

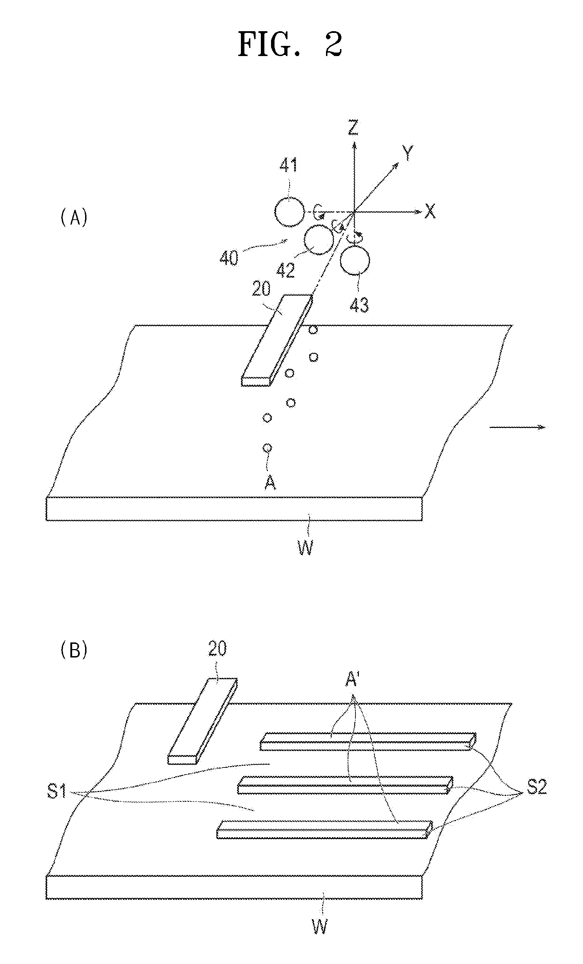

FIG. 1 illustrates an application and removal system 2 according to the first embodiment of the present invention. FIG. 2(A) illustrates a schematic view of coating a non-treated surface S2 of a coating object W with a coating material A by an inkjet unit 20 of an application device 10 according to the first embodiment of the present invention, and FIG. 2(B) illustrates a state of the coating object W after the coating. Also, a direction in which the coating objet W is transported is denoted as an X direction (first direction), a direction in which a column of inkjet nozzles 24 of the inkjet unit 20 is arranged is denoted as a Y direction (second direction), and a direction perpendicular to the X direction and the Y direction is denoted as a Z direction (third direction).

As illustrated in FIG. 1, the application and removal system 2 includes the application device 10 and a removal device 70.

### <Application Device 10>

As illustrated in FIG. 2A, the application device 10 coats only the non-treated surface S2 of the coating object W, which includes a treated surface S1 subjected to a surface treatment and the non-treated surface S2 not subjected to the surface treatment, with the heat-fusible coating material A that is a solid at room temperature and is liquefied by heating. The treated surface S1 and the non-treated surface S2 constitute a landing surface S.

The application device 10 includes the inkjet unit 20 for discharging the coating material A toward the coating object W, a supply unit 30 for supplying the molten coating material A to the inkjet unit 20, and a heating means 31 which is provided in the supply unit 30 and melts the coating material A.

The surface treatment denotes that the surface of the coating object W is modified by a chemical or physical method, and for example, the surface treatment may include a chemical modification method, such as plating, etching, electroforming, and surface roughening, and a physical modification method such as polishing and sputtering.

The coating material A of the present embodiment is a masking agent A' including paraffin. The coating material A is composed by including paraffin as well as a colorant and other additives if necessary. The detailed composition of the coating material A will be described later. Hereinafter, the coating material A before being coated on the coating object W is referred to as "coating material A", and the coating material A after being coated on the coating object W is referred to as "masking agent A"'.

The coating object W, for example, is a wiring board or an electronic component. The wiring board may include a printed circuit board represented by a motherboard, a central processing unit (CPU), a chip set, a ceramic substrate, and a package substrate represented by a touch panel substrate. Also, the electronic component may include a semiconductor chip, connectors, and sockets. These wiring boards or electronic components may be formed of a resin film, such as a glass epoxy material, a polyimide-based film, a polyamide-based film, a polyester-based film, a polytetrafluoroethylene-based film, a polyphenylene sulfide-based film, a polyethylene naphthalate-based film, and a liquid crystal polymer-based film, a bismaleimide-triazine (BT) resin, a silicon wafer, glass, a liquid crystal film, aramid, or ceramic. Also, these wiring boards or electronic components may be formed by forming a conductive layer, such as copper, silver, tin, or gold, on the above materials and, for example, may be formed of a metal thin film coated resin film in which a metal thin film is formed on the surface of a resin film such as a polyimide film.

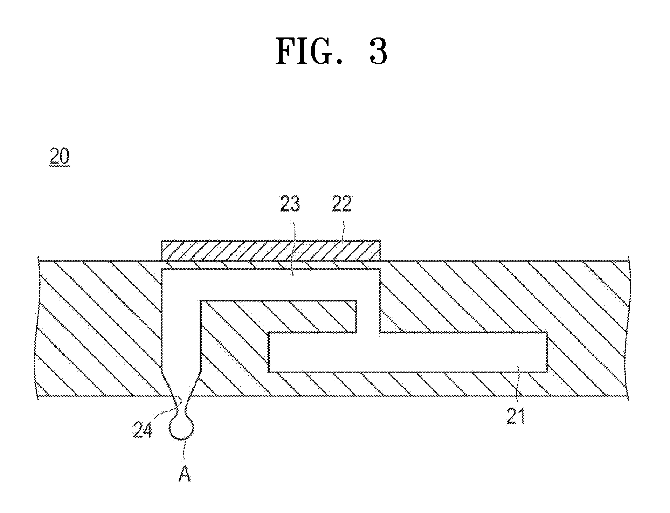

FIG. 3 is a sectional view illustrating discharge of the coating material A from the inkjet unit 20.

As illustrated in FIG. 3, the inkjet unit 20 includes an ink flow channel 21 through which the coating material A in a liquid form flows, an ink pressurizing chamber 23 which is pressurized by a piezo 22, and an inkjet nozzle 24 though which the coating material A pressurized in the ink pressurizing chamber 23 is discharged. A column of the inkjet nozzles 24 is only arranged in the Y direction as illustrated in FIG. 2. Since the piezo inkjet technique is a known technique, the detailed descriptions thereof are omitted. Also, a heating unit for maintaining a molten state of the coating material A may be provided in the inkjet unit 20. Furthermore, the column of the inkjet nozzles 24 may be provided in plurality.

A temperature of the coating material A during the coating may be above a melting point + 20°C in terms of the improvement of applicability, and for example, may be above the melting point + 30°C. An upper limit of the temperature is not particularly limited as long as it is less than a boiling point of paraffin. However, the upper limit may be 180°C or less in terms of heat resistance of the inkjet unit 20, and for example, may be 140°C. In addition, or instead, the upper limit, for example, may be the melting point of the coating material A + 50°C or less.

A thickness of the masking agent A' is not particularly limited. However, the thickness may be in a range of 10 µm to 100 µm, and for example, may be in a range of 10 µm to 50 µm. In the case that the thickness of the masking agent A' is 10 µm or more, the occurrence of pinholes may be suppressed. Accordingly, the masking agent A' may sufficiently function as a mask in a process of dipping in a plating solution which will be described later. In the case in which the thickness of the masking agent A' is 100 µm, a decrease in adhesion between the masking agent A' and the coating object W or the occurrence of cracks due to the increase in internal stress may be suppressed.

Also, a width of the masking agent A' in the Y direction is not particularly limited, and is determined according to a pattern to be formed. The width may be formed to a predetermined width by connecting the plurality of inkjet units 20 in the Y direction.

The supply unit 30 includes a tank 32 into which the coating material A in a solid state or a liquid state may be introduced, a connecting part 33 connecting between the inkjet unit 20 and the tank 32, and a sending unit 34 for sending the molten coating material A in the tank 32 to the inkjet unit 20 though the connecting part 33.

The heating means 31 includes a first heating unit 31A provided in the tank 32 for melting the coating material A and a second heating unit 31B provided on the connecting part 33 for maintaining the molten state of the coating material A. The first heating unit 31A, for example, is a halogen lamp heater, but the present invention is not limited thereto. Also, the second heating unit 31B, for example, is a coil-shaped heater provided on the outer periphery of the connecting part 33, but the present invention is not limited thereto.

The tank 32 is not particularly limited as long as it is formed of a material that may withstand the heating of the first heating unit 31A, and for example, the tank 32 may be a heat resistant acrylic case.

The connecting part 33 is not particularly limited as long as it is formed of a material that may withstand the heating of the second heating unit 31B and has flexibility, and for example, the connecting part 33 may be a heat resistant silicon tube.

The sending unit 34 is composed of a pump mechanism.

The application device 10 also includes an adjusting unit 40 which may adjust the position of the inkjet unit 20 by three-dimensionally moving the inkjet unit 20 against the coating object W and may freely adjust the position, on which the coating material A is coated, with respect to the coating object W, a transport unit 50 for transporting the coating object W with respect to the inkjet unit 20, and a temperature control unit 60 provided in the transport unit 50 for controlling the temperature of the coating object W.

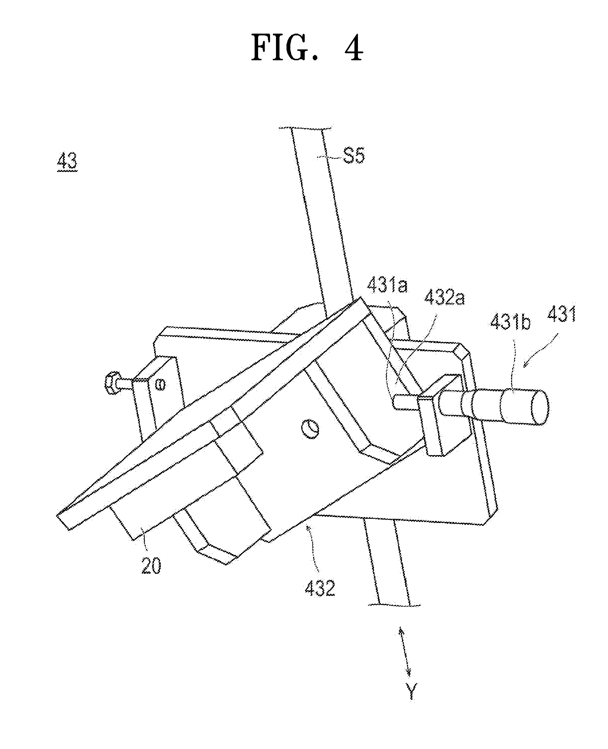

FIG. 4 is a perspective view illustrating a schematic configuration of the adjusting unit 40.

As illustrated in FIG. 2, the adjusting unit 40 includes a first rotating part 41, a second rotating part 42, and a third rotating part 43 which respectively rotate the inkjet unit 20 with respect to the coating object W around axes in the X direction, Y direction, and Z direction. Also, since the first rotating part 41, the second rotating part 42, and the third rotating part 43 have the same configuration and are simple in FIG. 4, the descriptions of the first rotating part 41 and the second rotating part 42 are omitted. Hereinafter, the configuration of the third rotating part 43 will be described with reference to FIG. 4.

The third rotating part 43 rotates the inkjet unit 20 with respect to the coating object W around the axis in the Z direction to make the column of the inkjet nozzles 24 inclined with respect to the Y direction.

The third rotating part 43 includes a micrometer 431 and a case 432 to which the inkjet unit 20 is fixed.

The micrometer 431 includes a tip 431a provided at a front end and a rotating portion 431b provided at a rear end.

The case 432 is connected to a support S5 so as to be able to slide in the Y direction. According to this configuration, the inkjet unit 20 may slide in the Y direction and may apply the coating material A to a predetermined position (the non-treated surface S2) of the landing surface S.

The tip 431a moves back and forth by rotating the rotating portion 431b, and pushes a side 432a of the case 432. Accordingly, the case 432 is rotated around the axis in the Z direction and the inkjet unit 20 is rotated.

The rotating portion 431b is rotated by sending a signal from a controller (not shown) to a servo motor (not shown) connected to the rotating portion 431b. Also, the rotating portion 431b may be manually rotated.

The transport unit 50 is roll-to-roll type. The expression "roll-to-roll type" denotes coating object W storage and supply means in which the coating object W in the state of being wound on a roll is introduced and coated with the coating material A in the application device 10, and the coating object W is then rewound on the roll.

The temperature control unit 60 is attached to the transport unit 50 and controls the temperature of the coating object W during the transport. The temperature control unit 60, for example, is a halogen heater, but the present invention is not limited thereto.

The temperature of the coating object W when being transported by the transport unit 50 is not limited. However, the temperature may be in a range of 24°C to 60°C in terms of controlling the delamination of the masking agent A' due to the rapid shrinkage, and may be in a range of 50°C to 60°C in terms of improving ink diffusion after the coating. An upper limit of the temperature range is not particularly limited as long as it is less than a melting point of paraffin constituting the coating material A. However, the upper limit may be in a range of 24°C to 50°C in terms of the diffusion of the paraffin, and for example, may be in a range of 24°C to 30°C in terms of edge formation. Since the temperature of the coating object W may be appropriately controlled by this configuration, ink spillage may be prevented.

### <Removal Device 70>

The removal device 70 includes a cooling removal unit 71 which removes the coating material A, the masking agent A' including paraffin coated only on the non-treated surface S2, as a solid from the coating object W by a refrigerant 712 having a temperature less than the melting point of the paraffin. The refrigerant 712, for example, is water and is stored in a water tank 711. Since the cooling removal unit 71 solidifies the paraffin included in the masking agent A' by contacting the masking agent A' with the refrigerant 712 having a temperature less than the melting point of the paraffin, the cooling removal unit 71 removes the masking agent A' from the coating object W.

Also, the masking agent is removed by pure water in the present embodiment. However, the present invention is not limited thereto, and the refrigerant 712 may be a liquid or gas medium. As the liquid, an acidic, alkaline, or neutral liquid may be used, but there is a risk that the acidic and alkaline liquid may adversely affect, for example, may cause discoloration of a metal layer formed by a surface treatment such as plating. Thus, in the case that the liquid is used, it is preferable that the liquid is neutral. That is, it is preferred that the refrigerant is cold wind and/or a neutral liquid. For example, the refrigerant may be a neutral liquid. Examples of the cold wind may be cooling gas such as air, nitrogen, and carbon dioxide. The neutral liquid is not particularly limited as long as it does not dissolve paraffin, and the neutral liquid may be used by appropriately selecting a known liquid suitable for the used paraffin. Examples of the neutral liquid may be methyl ethyl ketone, acetone, diethyl ketone, methyl isobutyl ketone, methyl isopropyl ketone, cyclohexanone, ketone-based solvents, such as 3-heptanone and 4-heptanone, methanol, ethanol, n-propanol, isopropanol, n-butanol, i-butanol, t-butanol, 3-methyl-1-butanol, 1-pentanol, 2-pentanol, n-hexanol, cyclohexanol, 1-heptanol, 1-octanol, 2-octanol, 2-methoxyethanol, and alcohol-based solvents such as allyl alcohol, furfuryl alcohol, and phenol. Also, these materials may be used alone or a mixture of two or more thereof.

The temperature of the refrigerant 712 is not particularly limited as long as it is less than the melting point of the paraffin and is a temperature at which delamination may occur due to the shrinkage of the paraffin. Since the shrinkage of the paraffin depends on the melting point of the paraffin, the shrinkage may be appropriately set according to the melting point of the paraffin. Specifically, in order to improve delamination properties, the temperature of the refrigerant 712 may be below the melting point of the paraffin - 60°C, may be preferably below the melting point of the paraffin - 70°C, and more preferably, below the melting point of the paraffin - 80°C. For example, the temperature of the refrigerant may be 25°C or less in terms of convenience, may be preferably 10°C or less, and more preferably 5°C or less. In particular, the temperature of the refrigerant may be 0°C or less in terms of the reduction of delamination time. A lower limit of the temperature of the refrigerant is not particularly limited. For example, in the case that liquid nitrogen is used, the temperature of the refrigerant may be set as -196°C.

The removal device 70 further includes a cooling-side recovery unit 72 for recovering the masking agent A' in a solid state, which has been removed by the cooling removal unit 71, from the refrigerant, and the masking agent A' recovered in the cooling-side recovery unit 72 is reused as the coating material A.

The cooling-side recovery unit 72 recovers the masking agent A' which is precipitated or floats in the water tank 711 after being removed in the cooling removal unit 71. The cooling-side recovery unit 72 is not limited as long as it has a configuration which may withstand the weight of the recovered masking agent A' or may recover only the masking agent A'.

The masking agent A' recovered in the cooling-side recovery unit 72 may be reused as it is as the coating material. Also, if necessary, impurities in the recovered masking agent A', for example, metal pieces or metal particles produced by plating, dirt, or dust may be removed and reused. However, if necessary, the recovered masking agent A' may be purified and reused.

### <Coating Material A>

Hereinafter, the coating material A applied by the application device 10 according to the present embodiment and the coating object W coated with the coating material A will be described.

In the present specification, the term "paraffin" denotes alkanes (chain saturated hydrocarbons having a general formula of CₙH₂ₙ₊₂) having 20 or more carbon atoms. Since paraffin has high chemical stability and high corrosion resistance, the paraffin has excellent chemical resistance (alkali/acid resistance) with respect to a surface treatment agent such as a plating solution and an etching solution. Therefore, a composition including paraffin may be used as the masking agent A' during a surface treatment such as plating or etching. As described later, the surface treatment using the masking agent A' including paraffin is performed in such a manner that a surface treatment, such as plating or etching, is performed after the coating material A is coated on the non-treated surface of the coating object W not subjected to the surface treatment (mask pattern is formed), and the masking agent A' is then solidified by being cooled to a temperature less than the melting point. Thus, the masking agent A' is removed. Also, paraffin may have high stability to the human body and handling of the masking agent A' may be improved by preparing the masking agent A' using the paraffin.

Paraffin usable in the present invention is not particularly limited. However, the paraffin may be chain saturated hydrocarbons having 20 to 80 carbon atoms, and for example, may be chain saturated hydrocarbons having 20 to 40 carbon atoms. Also, the paraffin may have a linear shape or a branched shape. Paraffin may be formed of a homogeneous material, but typically, is a mixture of two or more chain saturated hydrocarbons (paraffins) having different carbon numbers.

A number-average molecular weight (Mₙ) of the paraffin is in a range of 220 to 480, may be in a range of 220 to 300, and for example, may be in a range of 220 to 260. As a result, the melting point of the paraffin may be adjusted to a desired range, and the adhesion to the coating object W and the delamination properties during cooling may be improved.

Also, an average number of carbon atoms of the paraffin may be in a range of 20 to 40. In general, the higher the number of carbon atoms is, the higher the melting point of the paraffin is. Thus, the melting point of the paraffin may be adjusted to a desired range by changing the number of carbon atoms included, and the adhesion to the coating object W and the delamination properties during cooling may be improved.

The melting point of the paraffin varies depending on the application of the coating material A, wherein it is desirable to use paraffin that is in a solid state at room temperature (25°C). The melting point of the paraffin may be 40°C or more, may be preferably 50°C or more, and more preferably 60°C or more. In particular, the melting point of the paraffin may be 65°C or more. It is necessary to perform the removal of the masking agent A' to be later described or the surface treatment (plating and etching) at a temperature less than the melting point of the paraffin. Thus, in this case, the removal of the masking agent A' including paraffin or the surface treatment may be easily performed, and it is desirable because the choice of the treatment temperature is wide. Also, an upper limit of the melting point is not particularly limited. However, it is preferred that the melting point is 200°C or less because the coating of the coating material A including paraffin may be performed under smooth conditions. In general, the shrinkage during cooling increases when the melting point of the paraffin increases, and thus, cracks may easily occur in the paraffin. From this point of view, the melting point may be 150°C or less, preferably 100°C or less, and more preferably 85°C or less.

Paraffin wax or synthetic paraffins of petroleum/mineral origin prepared by separation and purification from the vacuum distillation petroleum oil as defined in JIS K 2235:2009, or synthetic waxes may be used as the paraffin. Proper examples of commercial products may be "PARAFFINWAX" series by NIPPON SEIRO CO., LTD.

The coating material A may only be composed of the paraffin. However, the coating material A may be a masking composition including paraffin as well as a colorant and other additives if necessary.

The coating material A may include a colorant. Since paraffin is semitransparent to white at room temperature, the visibility of the coating material A coated on the non-treated surface may be improved by the addition of the colorant. The colorant is not particularly limited, and generally known pigments and/or dyes may be used.

As the pigment, for example, magenta pigments such as Pigment Red 3, 5, 19, 22, 31, 38, 43, 48:1, 48:2, 48:3, 48:4, 48:5, 49:1, 53:1, 57:1, 57:2, 58:4, 63:1, 81, 81:1, 81:2, 81:3, 81:4, 88, 104, 108, 112, 122, 123, 144, 146, 149, 166, 168, 169, 170, 177, 178, 179, 184, 185, 208, 216, 226, 257, Pigment Violet 3, 19, 23, 29, 30, 37, 50, 88, Pigment Orange 13, 16, 20, 36; cyan pigments such as Pigment Blue 1, 15, 15:1, 15:2, 15:3, 15:4, 15:6, 16, 17-1, 22, 27, 28, 29, 36, 60; green pigments such as Pigment Green 7, 26, 36, 50; yellow pigments such as Pigment Yellow 1, 3, 12, 13, 14, 17, 34, 35, 37, 55, 74, 81, 83, 93, 94, 95, 97, 108, 109, 110, 137, 138, 139, 153, 154, 155, 157, 166, 167, 168, 180, 185, 193; black pigments such as Pigment Black 7, 28, 26; and white pigments, such as Pigment White 6, 18, 21, may be used in accordance with the purpose.

As the dye, an oil-soluble dye that is substantially insoluble in water may be used, and for example, C. I. Solvent Black 3, 7, 27, 29, and 34; C. I. Solvent Yellow 14, 16, 19, 29, 30, 56, 82, 93, and 162; C. I. Solvent Red 1, 3, 8, 18, 24, 27, 43, 49, 51, 72, 73, 109, 122, 132, and 218; C. I. Solvent Violet 3; C. I. Solvent Blue 2, 11, 25, 35, 38, 67, and 70; C. I. Solvent Green 3 and 7; and C. I. Solvent Orange 2 may be used. Also, in the present specification, the expression "oil-soluble dye" denotes that solubility in water (mass of dye that can be dissolved in 100g of water) at 25°C is 1g or less, and the solubility may be 0.5g or less, for example, 0.1g or less.

The pigments and/or dyes may be used alone or may be used in a mixture of two or more thereof.

When using the colorant such as the pigment present as a solid in the coating material A, an average particle diameter of the colorant is in a range of 1 µm to 20 µm, may be in a range of 1 µm to 5 µm, and for example, may be in a range of 1 µm to 2 µm. When the average particle diameter is within the above range, clogging of the inkjet nozzle 24 may be prevented and storage stability may be maintained.

The coating material A, if necessary, may include additives such as a dispersant for improving the dispersibility of the colorant, a surfactant for adjusting the surface tension of the coating material A, a viscosity modifier, an adhesion-imparting agent for improving adhesiveness, a plasticizer for imparting flexibility, or an antioxidant for imparting thermal stability.

The amount of the paraffin in the coating material A is in a range of 85 wt% or more to less than 100 wt% based on a total weight of the coating material A in terms of sufficiently exhibiting chemical resistance, may be in a range of 90 wt% or more to 99.99 wt% or less in terms of preventing a chemical reaction with the plating solution, and for example, may be in a range of 95 wt% or more to 99.99 wt% or less in terms of further preventing the chemical reaction with the plating solution.

The amount of the colorant in the coating material A is appropriately selected according to the intended use, wherein the amount of the colorant is in a range of 0.01 wt% to 10 wt% based on the total weight of the coating material A in consideration of the applicability and colorability of the coating material A, may be in a range of 0.01 wt% to 5 wt%, and for example, may be in a range of 0.01 wt% to 1 wt%.

The amount of other additives in the coating material A is not particularly limited as long as it does not impair the effects of the present invention. However, the amount of other additives may typically be in a range of 0.1 parts by weight or more to 10 parts by weight or less based on a total weight (100 parts by weight) of the colorant and paraffin.

The preparation of the coating material A including the colorant and/or additives may be performed by mixing paraffin in a molten state, colorant, and/or additives with each dispersion device, for example, a ball mill, a sand mill, an attritor, a roll mill, an agitator, a Henschel mixer, a colloid mill, an ultrasonic homogenizer, a pearl mill, a wet jet mill, and a paint shaker.

The coating material A may have a viscosity of 5 mPa/s to 30 mPa/s at 80°C. When the viscosity is within the above range, it is possible to employ various application devices including an inkjet type and various coating methods. In general, high viscosity may be preferred in terms of preventing ink spillage after discharging. However, when the viscosity is excessively high, there is a case where ink diffusion may be poor and a uniform coating surface may be difficult to be formed even if the resolution is increased. From this point of view, the viscosity may be in a range of 5 mPa/s to 20 mPa/s and for example, may be in a range of 8 mPa/s to 20 mPa/s. The viscosity of the coating material A may be adjusted to a desired range by adjusting a composition (type and content of the chain saturated hydrocarbon) of the paraffin constituting the coating material A or adding a viscosity modifier.

In the present embodiment, the coating material A was used in which 100 parts by weight of paraffin wax (melting point of 95°C) and 5 parts by weight of pigment as the colorant were mixed. The viscosity of the coating material A was measured using a rotary viscometer (e.g., TVB-35 by TOKI SANGYO CO., LTD.) and the result was 12 mPa/s at 80°C.

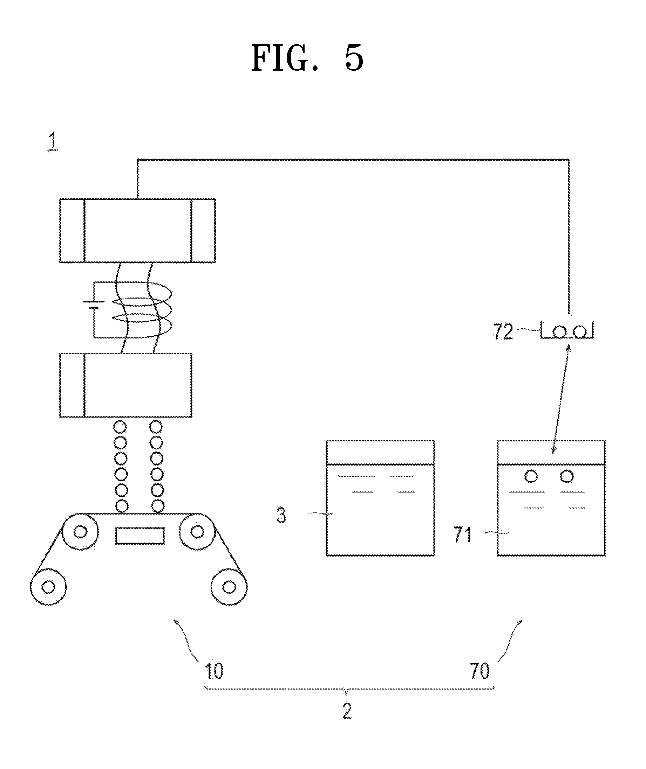

In the application and removal system 2 thus configured, a predetermined surface treatment is performed on the treated surface S1 of the coating object W by performing a predetermined surface treatment on the coating object W having the non-treated surface S2 coated with the masking agent A' and then removing the masking agent A' from the non-treated surface S2 of the coating object W. Hereinafter, a method of plating the treated surface S1 of the coating object W as an example will be described with reference to FIGS. 5 to 9.

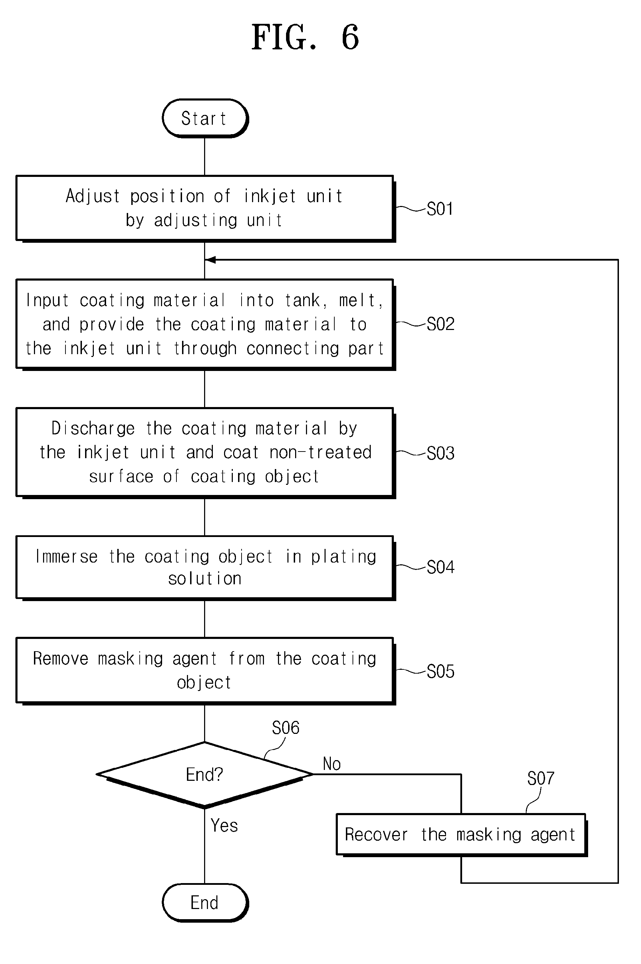

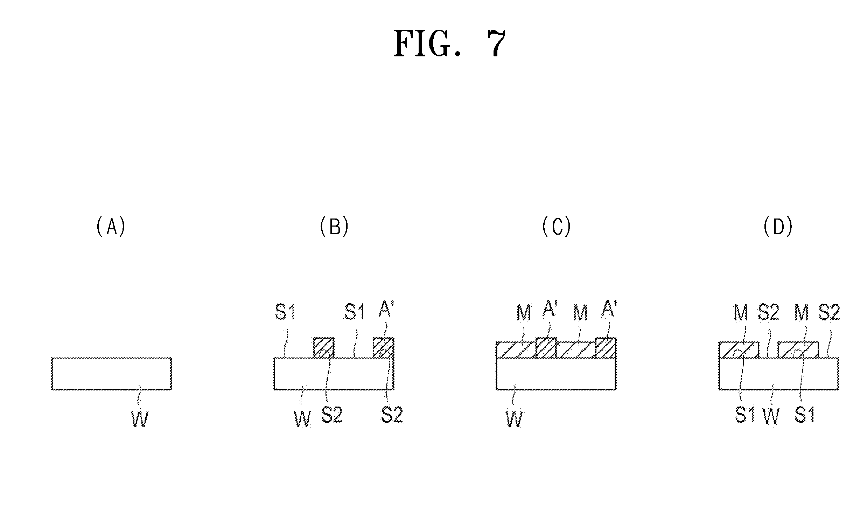

FIG. 5 illustrates a plating unit 1 including the application and removal system 2. The plating unit 1 includes the application and removal system 2 and a plating immersion unit 3. FIG. 6 is a flowchart illustrating a method of plating by the plating unit 1 of FIG. 5. FIG. 7 illustrates states when each process by the plating unit 1 of FIG. 5 is ended. FIGS. 7(A), 7(B), (C), and (D) illustrates the coating objects in an initial state, after the end of a discharge process, after dipping in a plating solution, and after the end of a cooling removal process, respectively.

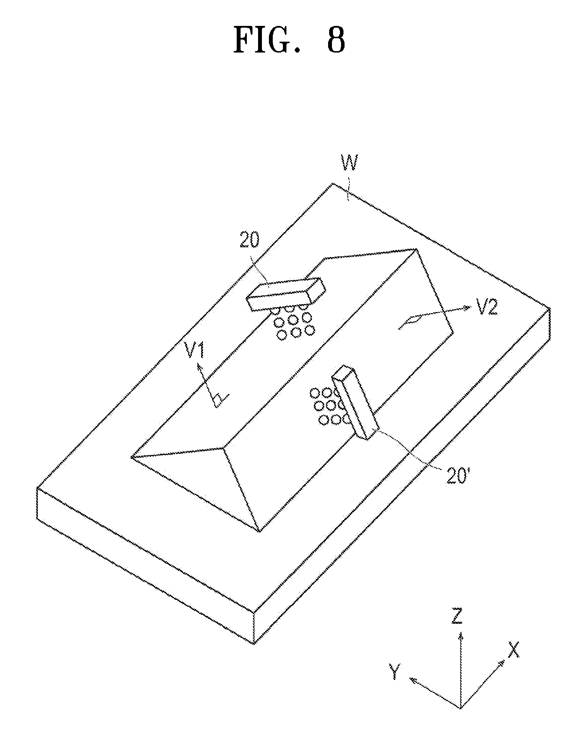

In S01, the position of the inkjet unit 20 is controlled by the adjusting unit 40 (adjusting process). In the present embodiment, as illustrated in FIG. 8, two application devices 10, i.e., two inkjet units 20 (first inkjet unit 20 and second inkjet unit 20') are provided. Specifically, when the coating object W has the non-treated surfaces S2 orthogonal to each other in two different directions V1 and V2, the first inkjet unit 20 is rotated around X axis and Y axis so as to discharge the coating material A in the V1 direction and the second inkjet unit 20' is rotated around the X axis and Y axis so as to discharge the coating material A in the V2 direction by the first rotating part 41 and the second rotating part 42.

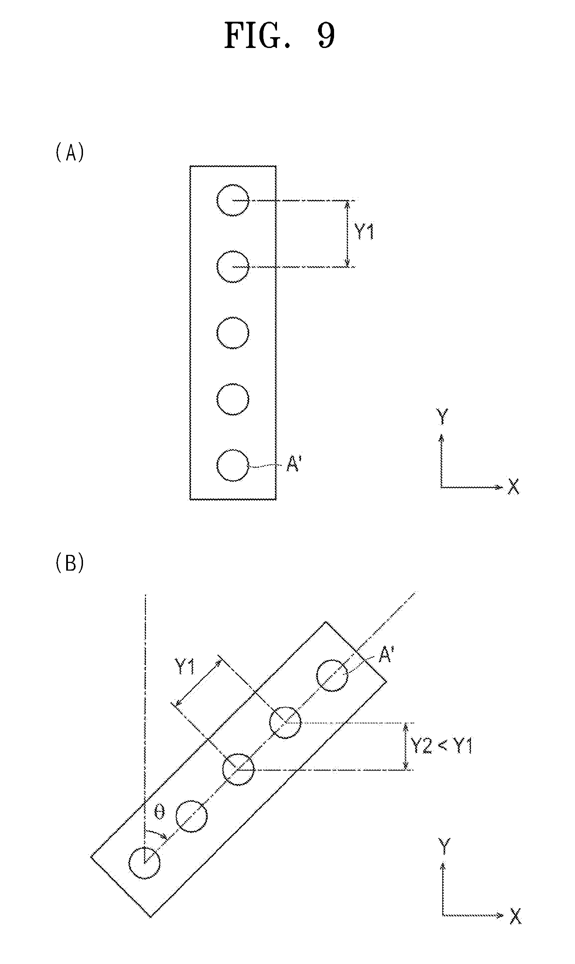

Also, as illustrated in FIG. 9, the inkjet unit 20 is rotated around Z axis by θ° with respect to the coating object W by the third rotating part 43. Since the inkjet unit 20 is rotated around the Z axis by θ°, the column of the inkjet nozzles 24 is inclined by θ° from the Y direction. If a pitch between the inkjet nozzles 24 is denoted as Y1, Y2, a component of the pitch between the inkjet nozzles 24 in the Y direction after the inclination, becomes Y1 x cos θ. Since the inkjet nozzles 24 are only provided in a row, Y2, the component of the pitch between the inkjet nozzles 24 in the Y direction after the inclination, may be easily calculated. Since Y2, the component of the pitch between the inkjet nozzles 24 in the Y direction after the inclination, is represented by Y1 x cos θ, Y2, the component of the pitch between the inkjet nozzles 24 in the Y direction, may be decreased, the continuously landed masking agent A' may be coated without having a gap in the Y direction even if the pitch (Y1) between the inkjet nozzles 24 is relatively greater than the diameter of the coating material A during discharging, and defects, in which plating is performed on the gap of the landed masking agent A' in the Y direction, may be prevented by setting the inclination angle θ close to 90°.

In S02, the coating material A is introduced into a tank 32, and melted to be supplied to the inkjet unit 20 though the connecting part 33 (supply process). Specifically, the coating material A in a solid state or a liquid state is introduced into the tank 32 (input process). The coating material A in a solid state is heated to 140°C by the first heating unit 31A provided in the tank 32 to be melted (melting process). The molten state of the coating material A is maintained by the second heating unit 31B provided in the outer periphery of the connecting part 33 (melt maintaining process), and the coating material A is sent from the tank 32 to the inkjet unit 20 by the sending unit 34 (sending process).

In S03, the coating material A is coated on the non-treated surface S2 of the coating object W by being discharged by the inkjet unit 20 (discharge process). Specifically, the coating material A in a liquid state supplied through the connecting part 33 flows through the ink channel 21 to enter into the ink pressurizing chamber 32. In order to coat only on the non-treated surface S2, the ink pressurizing chamber 32 is deformed by applying an appropriate voltage to the appropriate piezo 22 among the plurality of piezos 22. Then, the coating material A (120°C) is discharged from the inkjet nozzle 24 to coat on the non-treated surface S2 (see FIG. 7B).

In S04, the coating object W is immersed in the plating solution. Specifically, the coating object W having the non-treated surface S2 coated with the masking agent A' is immersed in the plating solution of the plating immersion unit 3. As a result, a metal layer M is formed on the treated surface S1 of the coating object W (see FIG. 7(C)). Also, a pretreatment may be performed on the coating object W before being immersed in the plating solution for the purpose of improving the adhesion between the coating object W and the metal layer M. Examples of the pretreatment may include cleaning processes, such as blasting, alkaline cleaning, acid cleaning, organic solvent cleaning, and bombardment treatment, etching treatment, and base layer formation. Examples of a constituent material of the metal layer M may be nickel (Ni), copper (Cu), silver (Ag), gold (Au), chromium (Cr), zinc (Zn), tin (Sn), and a Sn-lead (Pb) alloy. A thickness of the metal layer M formed by the plating is not particularly limited, but may be 0.5 µm or more in order to exhibit sufficient conductivity.

An upper limit of the thickness is not particularly limited. A method of plating is not particularly limited, and for example, a treatment, such as electroplating and electroless plating, may be performed. A temperature of the plating may vary depending on a type of the plating solution and the plating method (electroplating and electroless plating). Typically, with respect to the electroless plating, a temperature of the plating solution is in a range of 40°C to 80°C. With respect to the electroplating, the temperature of the plating solution is in a range of 20°C to 70°C, and may be in a range of 50°C to 65°C. However, in the case that an alkaline-based or cyan-based solution is generally used, the temperature of the electroplating is 50°C or more. Also, there are many cases where the electroless plating is performed at 50°C or more. In the present invention, the temperature is not limited as long as it prevents the melting of the masking agent A' during the plating, and the temperature may be less than the melting point of the paraffin constituting the masking agent A'. The plating may be performed below the melting point of the paraffin - 10°C. In a particularly preferred embodiment, the masking agent A' is formed by using paraffin having a melting point of the plating temperature (temperature of the plating solution) + 10 to 50°C, for example, the plating temperature (temperature of the plating solution) + 10 to 30°C. That is, it is particularly preferred that the plating is performed at a temperature of the melting point of the paraffin constituting the masking agent A'-10 to 50°C, for example, the melting point of the paraffin -10 to 30°C.

Hereinafter, examples of the plating solution and plating conditions according to the present embodiment are presented.

**[Table 1]**

| Acid gold plating solution | | | |
|---|---|---|---|
| | Low concentration bath | High concentration bath | 23K bath |
| Potassium gold cyanide | 1-4 g/L | 10-30 g/L | 8 g/L |
| Citrate salts | Na salt 40 g/L | NH₄ salt 40 g/L | Acid+Na salt 80 g/L |
| Citric acid | 40 g/L | 40 g/L | |
| Nickel sulfamate | | | 3 g/L |
| Zinc acetate | | | 0.3 g/L |
| pH | 3-6 | 2.5-6.5 | 4-5 |
| | | | |
| Temperature (°C) | Room temperature | 30-60 | 21 |
| Cathode current density (A/dm²) | 0.5-1.0 | 0.1-0.8 | 1 |

The coating object W is immersed in the plating solution (pH = 4, the plating solution presented in Table 1) at 65°C for 1 hour and a 14 K gold plating layer having a thickness of 0.2 µm to 1 µm is formed.

In S05, the masking agent A' is removed from the coating object W (cooling removal process). Specifically, the coating object W having the treated surface S1 coated with the metal layer M and the non-treated surface S2 coated with the masking agent A' is immersed in water in the water bath 711 of the removal device 70. As a result, the masking agent A' coated on the non-treated surface S2 is removed from the non-treated surface S2 (see FIG. 7(D)). Immersion time varies depending on the temperature of the liquid. However, the immersion time typically may be in a range of 30 seconds to 5 minutes and for example, may be in a range of 5 minutes to 30 minutes. Also, if necessary, ultrasonic vibration may be applied during the immersion.

In S06, whether the plating is ended is determined. When it is determined that the plating is ended (S06: YES), the process is ended.

In contrast, when it is determined that the plating is not ended (S06: NO), the process returns to S02 after S07 is performed.

In S07, the masking agent A' removed in S05 is recovered by the cooling-side recovery unit 72 (cooling-side recovery process). Specifically, the masking agent A' in a solid form, which is removed from the non-treated surface S2 and floats or is precipitated in the water bath 711, is recovered. The recovered masking agent A' is reintroduced into the tank 32 so that the recovered masking agent A' is reused as the coating material A.

Thus, according to the method of plating by the processes of the flowchart illustrated in FIG. 6, the plating may be highly accurately and easily performed on a microscopic area.

Also, according to the application device 10 according to the present embodiment, since the masking agent may be accurately coated on the entire non-treated surface S2, unnecessary portions are not coated with the plating solution. Thus, the waste of plating materials may be prevented.

### <Second Embodiment>

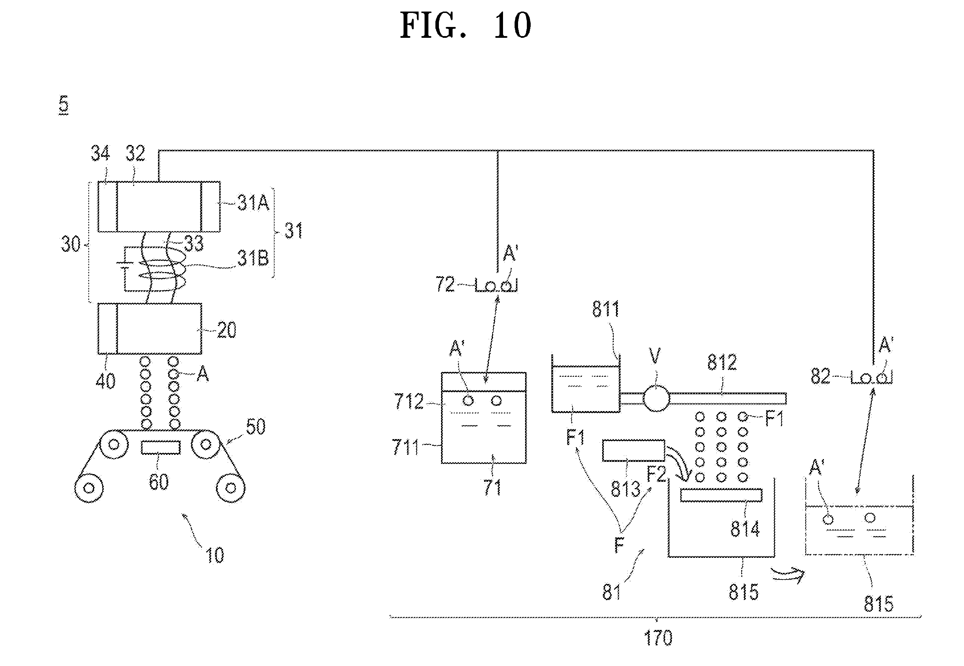

Subsequently, an application and removal system 5 according to a second embodiment of the present invention will be described with reference to FIG. 10. The present embodiment is different from the first embodiment in terms of the fact that a removal device 170 further includes a melt removal unit 81 and a melt-side recovery unit 82. Hereinafter, the descriptions overlapping with those described in the application and removal system 2 according to the first embodiment are omitted, and only the characteristic parts of the application and removal system 5 according to the present embodiment will be described.

As illustrated in FIG. 10, the application and removal system 5 according to the present embodiment includes an application device 10 and the removal device 170. The removal device 170 includes a cooling removal unit 71, a cooling-side recovery unit 72, a melt removal unit 81, and a melt-side recovery unit 82. Since configurations of the cooling removal unit 71 and the cooling-side recovery unit 72 are the same as those of the first embodiment, the detailed description thereof are omitted.

The melt removal unit 81 melts and liquefies the coating material A, which remains on the non-treated surface S2 after the removal by the cooling removal unit 71, by a fluid F having a temperature above the melting point of the paraffin and removes the molten and liquefied coating material A from the coating object W.

The melt removal unit 81 includes a liquid storage part 811, a liquid dripping part 812, a hot air supply part 813, a placing part 814, and a liquid recovery part 815.

The liquid storage part 811 stores a liquid F1. In the liquid storage part 811, a heat source (not shown) is provided to control the temperature of the liquid F1.

The liquid dripping part 812 drops the liquid F1 on the coating object W placed on the placing part 814. When a value V is open, the liquid F1 is supplied from the liquid storage part 811 having the liquid F1 stored therein and the liquid dripping part 812 drops the liquid F1.

The hot air supply part 813 supplies hot air F2 to the coating object W placed on the placing part 814.

The liquid recovery part 815 recovers the liquid F 1 and the masking agent A' melted by the liquid F1.

The liquid F1 and the hot air F2 constitute the fluid F.

The liquid F1, for example, is hot water. Also, the liquid F1 is not limited thereto and a liquid, such as a refrigerant 712, may be used. The temperature of the liquid F1 is not particularly limited as long as it is above the melting point of the paraffin. Furthermore, the temperature of the hot air F2 is not particularly limited as long as it is above the melting point of the paraffin.

The melt-side recovery unit 82 may solidify the masking agent A' in a liquid state that has been removed by the melt removal unit 81, and may then recover the masking agent A'. The masking agent A' recovered in the melt-side recovery unit 82 is reused as the coating material A.

The melt-side recovery unit 82 recovers the masking agent A' which is precipitated or floats in the liquid recovery part 815 after a predetermined period of time by being removed in the melt removal unit 81 and being recovered in the liquid recovery part 815. The melt-side recovery unit 82 is not particularly limited as long as it has a configuration which may withstand the weight of the recovered masking agent A' and may recover only the masking agent A'.

The masking agent A' recovered in the melt-side recovery unit 82 may be reused as it is as the coating material A. Also, if necessary, impurities in the recovered masking agent A', for example, metal pieces or metal particles produced by plating, dirt, or dust may be removed and reused. However, if necessary, the recovered masking agent A' may be purified and reused.

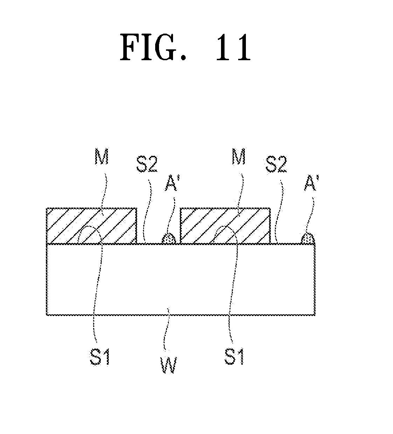

In the application and removal system 5 thus configured, a predetermined surface treatment is performed on the treated surface S1 of the coating object W by performing a predetermined surface treatment on the coating object W having the non-treated surface S2 coated with the masking agent A' and then removing the masking agent A' from the non-treated surface S2 of the coating object W. Hereinafter, a method of plating the treated surface S1 of the coating object W as an example will be described with reference to FIGS. 6 and 11. Also, since the processes from S01 to S04 illustrated in FIG. 6 are the same as those of the first embodiment, the processes after S05 will be described.

In S05, the masking agent A' is removed from the coating object W (cooling removal process, melt removal process). Specifically, as described in the first embodiment, a cooling removal process is first performed. FIG. 11 illustrates the coating object W after the cooling removal process. As illustrated in FIG. 11, the masking agent A' remains on the non-treated surface S2 of the coating object W. Subsequently, the coating object W is taken out from the water bath 711 and is placed on the placing part 814. Thereafter, the hot air supply unit 813 supplies the hot air F2 to the coating object W to melt the masking agent A' remaining on the non-treated surface S2 of the coating object W. Subsequently, the valve V is open, and the liquid dripping part 812 drops the liquid F1 stored in the liquid storage part 811 on the non-treated surface S2 of the coating object W. As a result, the liquid F1 and the masking agent A' melted by the liquid F1 are recovered in the liquid recovery part 815.

In S06, whether the plating is ended is determined. When it is determined that the plating is ended (S06: YES), the process is ended.

In contrast, when it is determined that the plating is not ended (S06: NO), the process returns to S02 after S07 is performed.

In S07, the masking agent A' removed in S05 is recovered by the cooling-side recovery unit 72 and the melt-side recovery unit 82 (cooling-side recovery process and melt-side recovery process). Since a recovering method is the same as that of the first embodiment, the detailed descriptions are omitted.

### <Third Embodiment>

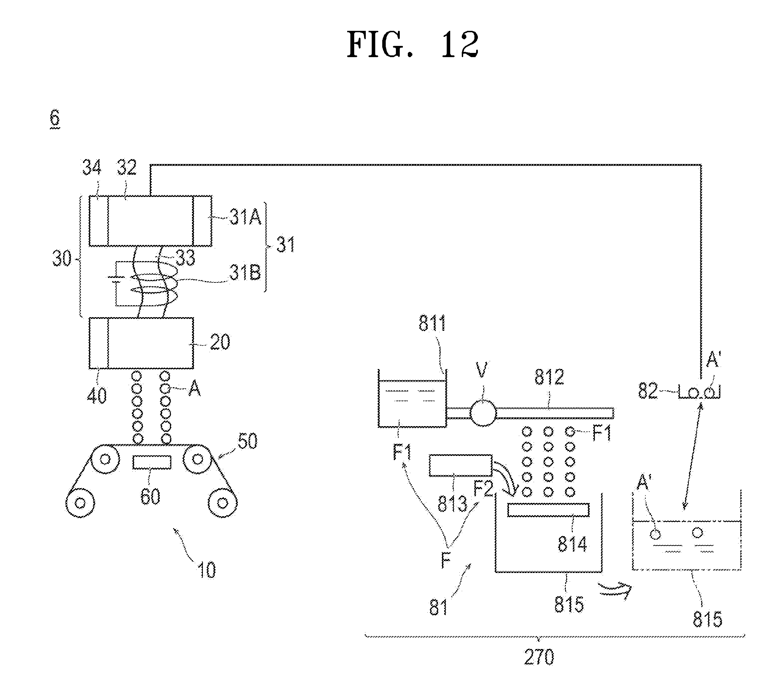

Subsequently, an application and removal system 6 according to a third embodiment of the present invention will be described with reference to FIG. 12. The present embodiment is different from the first embodiment and the second embodiment in terms of the fact that a removal device 270 is composed of a melt removal unit 81 and a melt-side recovery unit 82.

As illustrated in FIG. 12, the application and removal system 6 according to the present embodiment includes the melt removal unit 81 which removes the coating material A from the coating object W by melting and liquefying the coating material A, that is, the masking agent A' including heat-fusible paraffin that is a solid at room temperature and is liquefied by heating, which is only coated on the non-treated surface S2 of the coating object W including the treated surface S1 subject to a surface treatment and the non-treated surface S2 not subjected to the surface treatment, by the liquid F1 having a temperature above the melting point of the paraffin. Also, the application and removal system 6 includes the melt-side recovery unit 82 which solidifies the masking agent A' in a liquid form removed by the melt removal unit 81 and then recovers the solidified masking agent A', and reuses the masking agent A' recovered in the melt-side recovery unit 82 as the coating material A. Since configurations of the melt removal unit 81 and the melt-side recovery unit 82 are the same as those of the second embodiment, the detailed description thereof are omitted.

Hereinafter, a modified example of the above-described embodiments will be described.

### (Modified Example)

In the above-described embodiments, the position of the inkjet unit 20 is adjusted by the adjusting unit 40 to discharge the coating material A in a predetermined direction. However, the adjusting unit 40 may not be provided, the inkjet unit may be held by a holder that is already fixed to discharge in a predetermined direction, and the coating material A may be discharged.

Also, in the above-described embodiments, the sending unit 34 is composed of a pump mechanism, but the sending unit 4 may be composed of a natural flow-down mechanism in which the molten coating material A is sent by flowing down from a higher place to a lower place by disposing the tank 32 above the inkjet unit 20.

In the above-described embodiments, two inkjet units 20 are provided, but the number of the inkjet unit 20 may be one or three or more.

In the above-described embodiments, the position of the inkjet unit 20 is adjusted with respect to the coating object W by the adjusting unit 40. However, the position of the coating object W may be adjusted with respect to the inkjet unit 20 by the adjusting unit 40.

In the above-described embodiments, the coating material A is melted by the heating means 31 and the surface treatment is then performed in air. However, the melting of the coating material A and the surface treatment may be performed in a constant temperature bath.

Furthermore, in the above-described embodiments, plating is performed as the surface treatment, but other surface treatments, such as etching, may be performed.

The present application is based on Japanese Patent No. 2012-142499 filed on June 25, 2012 and Japanese Patent No. 2013-047545 filed on March 11, 2013, and disclosure thereof is referenced and incorporated as a whole.

The above-disclosed subject matter is to be considered illustrative, and not restrictive, and the appended claims are intended to cover all such modifications, enhancements, and other embodiments, which fall within the true spirit and scope of the present invention. Thus, to the maximum extent allowed by law, the scope of the present invention is to be determined by the broadest permissible interpretation of the following claims and their equivalents, and shall not be restricted or limited by the foregoing detailed description.

## Claims

1. An application device coating only a non-treated surface of a coating object, which comprises a treated surface subjected to a surface treatment and the non-treated surface not subjected to the surface treatment, with a heat-fusible coating material that is a solid at room temperature and is liquefied by heating, the application device comprising:
an inkjet unit for discharging the molten coating material toward the coating object;
a supply unit for supplying the molten coating material to the inkjet unit; and
a heating means which is provided in the supply unit and melts the coating material.

2. The application device of claim 1, wherein the supply unit comprises:
a tank into which the coating material in a solid state or a liquid state is introduced;
a connecting part connecting between the inkjet unit and the tank; and
a sending unit for sending the molten coating material in the tank to the inkjet unit though the connecting part, and
wherein the heating means comprises:
a first heating unit provided in the tank for melting the coating material; and
a second heating unit provided on the connecting part for maintaining a molten state of the coating material.

3. The application device of claim 2, wherein the sending unit is composed of a pump mechanism or a natural flow-down mechanism in which the molten coating material is sent by flowing down from a higher place to a lower place by disposing the tank above the inkjet unit.

4. The application device of any one of claims 1 to 3, further comprising an adjusting unit which adjusts a position of the inkjet unit by three-dimensionally and relatively moving the inkjet unit against the coating object and freely adjusts a position of the coating object on which the coating material is coated.

5. The application device of claim 4, wherein the adjusting unit comprises a first rotating part and a second rotating part which incline the inkjet unit with respect to a landing surface by relatively rotating the inkjet unit with respect to the coating object around axes in a first direction and a second direction that are orthogonal to each other on the landing surface of the coating object on which the coating material is landed.

6. The application device of claim 5, wherein a column of inkjet nozzles provided in the inkjet unit is arranged in the second direction and the coating material is sequentially discharged along the first direction by the inkjet unit, and
wherein the adjusting unit further comprises a third rotating part which relatively rotates the inkjet unit with respect to the coating object around an axis in a third direction orthogonal to the landing surface and inclines the column of the inkjet nozzles with respect to the second direction.

7. The application device of any one of claims 1 to 6, further comprising another inkjet unit which discharges the coating material in a direction that is different from a direction in which the coating material is discharged by the inkjet unit.

8. The application device of any one of claims 1 to 7, wherein the coating material is a masking agent including paraffin.

9. The application device of claim 8, wherein a viscosity of the coating material at 80°C is in a range of 5 mPa/s to 30 mPa/s.

10. The application device of claim 8 or 9, wherein an amount of the paraffin is in a range of 85 wt% or more to less than 100 wt% based on a total weight of the masking agent.

11. The application device of any one of claims 1 to 10, further comprising:
a transport unit for relatively transporting the inkjet unit and the coating object; and
a temperature control unit which is provided in the transport unit and controls a temperature of the coating object.

12. A removal device comprising a cooling removal unit which removes a coating material, a masking agent including heat-fusible paraffin that is a solid at room temperature and is liquefied by heating, which is coated only on a non-treated surface of a coating object that includes a treated surface subjected to a surface treatment and the non-treated surface not subjected to the surface treatment, as a solid from the coating object by a refrigerant having a temperature less than a melting point of the paraffin.

13. The removal device of claim 12, further comprising a cooling-side recovery unit that recovers the masking agent in a solid form, which is removed by the cooling removal unit, from the refrigerant,
wherein the masking agent recovered in the cooling-side recovery unit is reused as the coating material of any one of claims 1 to 11.

14. A removal device comprising:
a cooling removal unit which removes a coating material, a masking agent including heat-fusible paraffin that is a solid at room temperature and is liquefied by heating, which is coated only on a non-treated surface of a coating object that includes a treated surface subjected to a surface treatment and the non-treated surface not subjected to the surface treatment, as a solid from the coating object by a refrigerant having a temperature less than a melting point of the paraffin; and
a melt removal unit which removes the coating material remaining on the non-treated surface, after the removal by the cooling removal unit, from the coating object by melting and liquefying the coating material by a fluid having a temperature above the melting point of the paraffin.

15. The removal device of claim 14, further comprising:
a cooling-side recovery unit that recovers the masking agent in a solid form, which is removed by the cooling removal unit, from the refrigerant; and
a melt-side recovery unit that solidifies the masking agent in a liquid form removed by the melt removal unit and recovers the solidified masking agent,
wherein the masking agents recovered in the cooling-side recovery unit and the melt-side recovery unit are reused as the coating material of any one of claims 1 to 11.

16. A removal device comprising a melt removal unit which removes a coating material, a masking agent including heat-fusible paraffin that is a solid at room temperature and is liquefied by heating, which is coated only on a non-treated surface of a coating object that includes a treated surface subjected to a surface treatment and the non-treated surface not subjected to the surface treatment, from the coating object by melting and liquefying the coating material by a fluid having a temperature above a melting point of the paraffin.

17. The removal device of claim 16, further comprising a melt-side recovery unit that solidifies the masking agent in a liquid form removed by the melt removal unit and recovers the solidified masking agent,
wherein the masking agent recovered in the melt-side recovery unit is reused as the coating material of any one of claims 1 to 11.

18. An application and removal system comprising:
an application device of any one of claims 1 to 11; and
a removal device of any one of claims 12 to 17.

19. An application method of coating a heat-fusible coating material, which is a solid at room temperature and is liquefied by heating, only on a non-treated surface of a coating object that includes a treated surface subjected to a surface treatment and the non-treated surface not subjected to the surface treatment, the application method comprising:
a supply process of supplying the molten coating material to an inkjet unit; and
a discharge process of discharging the coating material supplied in the supply process by the inkjet unit.

20. The application method of claim 19, wherein the supply process comprises:
an input process of inputting the coating material in a solid form or a liquid form into a tank;
a melting process of melting the coating material in a solid form input in the input process;
a sending process of sending the coating material melted in the melting process to the inkjet unit; and
a melt maintaining process of maintaining a molten state of the coating material in a connecting part connecting between the tank and the inkjet unit.

21. The application method of claim 19 or 20, further comprising an adjusting process of adjusting a position of the inkjet unit by three-dimensionally and relatively moving the inkjet unit with respect to the coating object before the discharge process and adjusting a position of the coating object on which the coating material is coated.

22. The application method of any one of claims 19 to 21, wherein the coating material is a masking agent including paraffin.

23. The application method of claim 22, wherein a viscosity of the coating material at 80°C is in a range of 5 mPa/s to 30 mPa/s.

24. The application method of claim 22 or 23, wherein an amount of the paraffin is in a range of 85 wt% or more to less than 100 wt% based on a total weight of the masking agent.

25. The application method of any one of claims 19 to 24, further comprising a transport process of relatively transporting the inkjet unit and the temperature-controlled coating object.

26. A removal method comprising a cooling removal process of removing a coating material, a masking agent including heat-fusible paraffin that is a solid at room temperature and is liquefied by heating, which is coated only on a non-treated surface of a coating object that includes a treated surface subjected to a surface treatment and the non-treated surface not subjected to the surface treatment, as a solid from the coating object by a refrigerant having a temperature less than a melting point of the paraffin.

27. The removal method of claim 26, further comprising a cooling-side recovery process of recovering the masking agent in a solid form, which is removed in the cooling removal process, from the refrigerant,
wherein the masking agent recovered by the cooling-side recovery process is reused as the coating material of any one of claims 19 to 25.

28. A removal method comprising:
a cooling removal process of removing a coating material, a masking agent including heat-fusible paraffin that is a solid at room temperature and is liquefied by heating, which is coated only on a non-treated surface of a coating object that includes a treated surface subjected to a surface treatment and the non-treated surface not subjected to the surface treatment, as a solid from the coating object by a refrigerant having a temperature less than a melting point of the paraffin; and
a melt removal process of removing the coating material remaining on the non-treated surface after the cooling removal process from the coating object by melting and liquefying the coating material by a fluid having a temperature above the melting point of the paraffin.

29. The removal method of claim 28, further comprising:
a cooling-side recovery process of recovering the masking agent in a solid form, which is removed in the cooling removal process, from the refrigerant; and
a melt-side recovery process of solidifying the masking agent in a liquid form removed in the melt removal process and recovering the solidified masking agent,
wherein the masking agents recovered by the cooling-side recovery process and the melt-side recovery process are reused as the coating material of any one of claims 19 to 25.

30. A removal method comprising a melt removal process of removing a coating material, a masking agent including heat-fusible paraffin that is a solid at room temperature and is liquefied by heating, which is coated only on a non-treated surface of a coating object that includes a treated surface subjected to a surface treatment and the non-treated surface not subjected to the surface treatment, from the coating object by melting and liquefying the coating material by a fluid having a temperature above a melting point of the paraffin.

31. The removal method of claim 30, further comprising a melt-side recovery process of solidifying the masking agent in a liquid form removed by the melt removal unit and recovering the solidified masking agent,
wherein the masking agent recovered by the melt-side recovery process is reused as the coating material of any one of claims 19 to 25.

32. An application and removal method comprising:
an application method of any one of claims 19 to 25; and
a removal method of any one of claims 26 to 31.
